# EUROPEAN PATENT APPLICATION

(11) **EP 4 020 517 A1**
(43) Date of publication of application: **29.06.2022**
(21) Application number: 20216933.0
(22) Date of filing: 23.12.2020
(51) Int. Cl.: H01J 37/12, H01J 37/28

(54) **ELECTRON-OPTICAL DEVICE**

(71) Applicant: ASML Netherlands B.V., 5500 AH Veldhoven (NL)
(72) Inventor: STEENBRINK, Stijn, Wilem, Herman, Karel, 5500 AH Veldhoven (NL); KONING, Johan, Joost, 5500 AH Veldhoven (NL); VAN SOEST, Jurgen, 5500 AH Veldhoven (NL); WIELAND, Marco, Jan-Jaco, 5500 AH Veldhoven (NL)
(74) Representative: ASML Netherlands B.V.

(57) **Abstract**

Disclosed herein is an electron-optical device, a lens assembly and an electron-optical column. The electron-optical device comprises an array substrate and an adjoining substrate and is configured to provide a potential difference between the substrates. An array of apertures is defined in each of the substrates for the path of electron beamlets. The array substrate has a thickness which is stepped so that the array substrate is thinner in the region corresponding to the array of apertures than another region of the array substrate.

## Description

### FIELD

The embodiments provided herein generally relate to an electron-optical device, a lens assembly and an electron-optical column.

### BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incidental particles or other processing step such as etching, deposition of chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a target at a relatively low landing energy. The beam of electrons is focused as a probing spot on the target. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the target.

By scanning the primary electron beam as the probing spot over the target surface, secondary electrons can be emitted across the surface of the target. By collecting these emitted secondary electrons from the target surface, a pattern inspection tool may obtain an image-like signal representing characteristics of the material structure of the surface of the target. In such inspection the collected secondary electrons are detected by a detector within the tool. The detector generates a signal in response to the incidental particle. As an area of the sample is inspected, the signals comprise data which is processed to generate the inspection image corresponding to the inspected area of the sample. The image may comprise pixels. Each pixel may correspond to a portion of the inspected area. Typically electron beam inspection tool has a single beam and may be referred to as a Single Beam SEM. There have been attempts to introduce a multi-electron beam inspection in a tool (or a 'multi-beam tool') which may be referred to as Multi Beam SEM (MBSEM).

Another application for an electron-optical column is lithography. The charged particle beam reacts with a resist layer on the surface of a substrate. A desired pattern in the resist can be created by controlling the locations on the resist layer that the charged particle beam is directed towards.

An electron-optical column may be an apparatus for generating, illuminating, projecting and/or detecting one or more beams of charged particles. The path of the beam of charged particles is controlled by electromagnetic fields (i.e. electrostatic fields and magnetic fields). Stray electromagnetic fields can undesirably divert the beam.

In some electron-optical columns an electrostatic field is typically generated between two electrodes. For systems with increased use of beam current there exists a need in multi-electron beam inspection tools to raise the landing energy of the multi-beam. Consequently the potential differences applied between two electrodes for example that form an electrostatic lens which is capable of operating the sub-beams of the multi-electron beam. There thus exists a risk of catastrophic electrostatic breakdown in using known architectures at the elevated potential differences.

### SUMMARY

The present invention provides a suitable architecture to enable the desired electron-optical performance at higher potential differences. According to a first aspect of the invention, there is provided an electron-optical device for manipulating electron beamlets, the device comprising: an array substrate in which an array of apertures is defined for the path of electron beamlets, the substrate having a thickness which is stepped so that the array substrate is thinner in the region corresponding to the array of apertures than another region of the array substrate; and an adjoining substrate in which another array of apertures is defined for the path of the electron beamlets; wherein the electron-optical device is configured to provide a potential difference between the substrates.

According to a second aspect of the invention, there is provided a lens assembly for manipulating electron beamlets, comprising the electron-optical device of any preceding claim.

According to a third aspect of the invention, there is provided a lens assembly for manipulating electron beamlets, comprising: an array substrate in which an array of apertures is defined for the path of electron beamlets; an adjoining substrate in which at least an aperture is defined for the path of the electron beamlets; and a protective resistor configured to provide controlled discharge in the lens of capacitance in a power line, wherein the lens assembly is configured to provide a potential difference between the substrates.

Advantages of the present invention will become apparent from the following description taken in conjunction with the accompanying drawings wherein are set forth, by way of illustration and example, certain embodiments of the present invention.

### BRIEF DESCRIPTION OF FIGURES

The above and other aspects of the present disclosure will become more apparent from the description of exemplary embodiments, taken in conjunction with the accompanying drawings.
Figure 1 is a schematic diagram illustrating an exemplary charged particle beam inspection apparatus.
Figure 2 is a schematic diagram illustrating an exemplary multi-beam electron-optical column that is part of the exemplary inspection apparatus of Figure 1.
Figure 3 is a schematic diagram of an exemplary electron-optical system comprising a collimator element array and a scan-deflector array that is part of the exemplary inspection apparatus of Figure 1.
Figure 4 is a schematic diagram of an exemplary electron-optical system array comprising the electron optical systems of Figure 3.
Figure 5 is a schematic diagram of an alternative exemplary electron-optical system that is part of the exemplary inspection apparatus of Figure 1.
Figure 6 is a schematic diagram of an exemplary electron-optical device that is part of the electron-optical systems of Figures 3, 4 and 5.
Figure 7 is a diagram illustrating the electrostatic field around a spacer in the electron-optical device of Figure 6.
Figure 8 is a schematic diagram of a spacer, which forms part of the electron-optical device, having an inner surface with a corrugated shape.
Figure 9 is a schematic diagram of an exemplary objective lens assembly comprising an insulated wire connection and a resistor.
Figure 10 is a schematic diagram of an exemplary objective lens assembly comprising connection by a metal-coated through-hole, also referred to as a 'via', in the spacer.
Figure 11 is a schematic diagram of an exemplary objective lens assembly comprising a flip chip connection.
Figure 12 is a schematic diagram of an exemplary objective lens assembly comprising a water cooling system operating at ground voltage.
Figure 13A, B and C are schematic diagrams of alternative exemplary detector arrangements.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

### DETAILED DESCRIPTION

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by inspection tools (such as a Scanning Electron Microscope ('SEM')) is desirable for maintaining high yield and low cost for IC chips.

A SEM comprises an scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as secondary electrons and/or backscattered electrons. The detection apparatus captures the secondary electrons and/or backscattered electrons from the target as the target is scanned so that the SEM may create an image of the scanned area of the target. A design of electron-optical tool embodying these SEM features may have a single beam. For higher throughput such as for inspection, some designs of apparatus use multiple focused beams, i.e. a multi-beam, of primary electrons. The component beams of the multi-beam may be referred to as sub-beams or beamlets. A multi-beam may scan different parts of a target simultaneously. A multi-beam inspection apparatus may therefore inspect a target much quicker, e.g. by moving the target at a higher speed, than a single-beam inspection apparatus.

In a multi-beam inspection apparatus, the paths of some of the primary electron beams are displaced away from the central axis, i.e. a mid-point of the primary electron-optical axis (also referred to herein as the charged particle axis), of the scanning device. To ensure all the electron beams arrive at the sample surface with substantially the same angle of incidence, sub-beam paths with a greater radial distance from the central axis need to be manipulated to move through a greater angle than the sub-beam paths with paths closer to the central axis. This stronger manipulation may cause aberrations that cause the resulting image to be blurry and out-of-focus. An example is spherical aberrations which bring the focus of each sub-beam path into a different focal plane. In particular, for sub-beam paths that are not on the central axis, the change in focal plane in the sub-beams is greater with the radial displacement from the central axis. Such aberrations and de-focus effects may remain associated with the secondary electrons from the target when they are detected, for example the shape and size of the spot formed by the sub-beam on the target will be affected. Such aberrations therefore degrade the quality of resulting images that are created during inspection.

An implementation of a known multi-beam inspection apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred with reference to electrons, throughout the present document may therefore be more generally be considered to be references to charged particles, and items referred to in reference to charged particles, with the charged particles not necessarily being electrons.

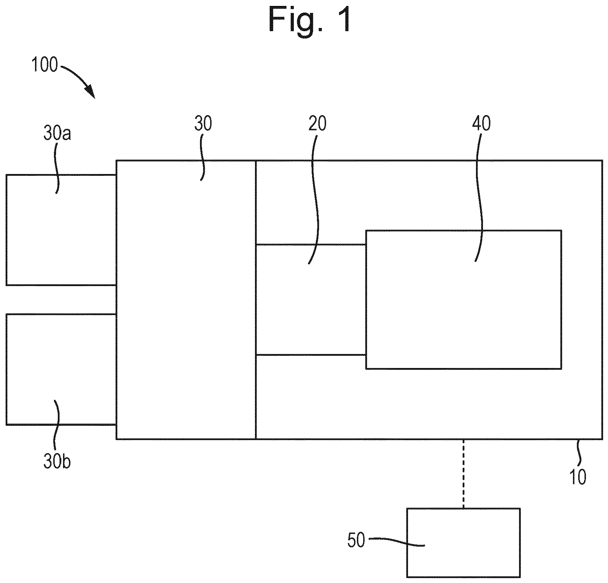

Reference is now made to Figure 1, which is a schematic diagram illustrating an exemplary charged particle beam inspection apparatus 100. The inspection apparatus 100 of Fig. 1 includes a vacuum chamber 10, a load lock chamber 20, an electron-optical column 40 (also known as an electron beam column), an equipment front end module (EFEM) 30 and a controller 50. The electron optical column 40 may be within the vacuum chamber 10.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be inspected (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the electron-optical column 40 by which it may be inspected. An electron-optical column 40 may comprise either a single beam or a multi-beam electron-optical apparatus.

The controller 50 is electronically connected to the electron-optical column 40. The controller 50 may be a processor (such as a computer) configured to control the charged particle beam inspection apparatus 100. The controller 50 may also include a processing circuitry configured to execute various signal and image processing functions. While the controller 50 is shown in Figure 1 as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it may be distributed over at least two of the component elements. While the present disclosure provides examples of main chamber 10 housing an electron beam inspection tool, it should be noted that aspects of the disclosure in their broadest sense are not limited to a chamber housing an electron beam column. Rather, it is appreciated that the foregoing principles may also be applied to other tools and other arrangements of apparatus that operate under the second pressure.

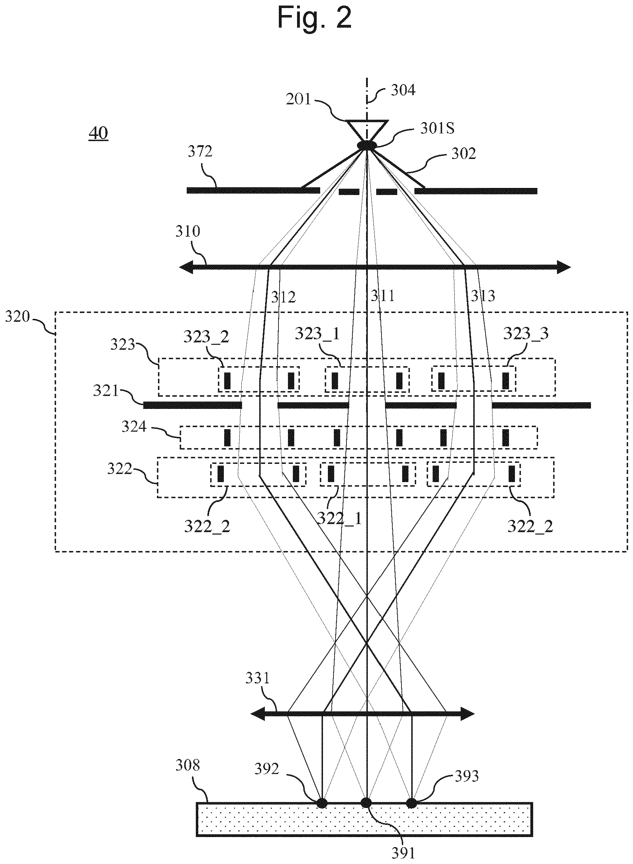

Reference is now made to Figure 2, which is a schematic diagram of an exemplary multi-beam electron-optical column 40 of the inspection apparatus 100 of Figure 1. In an alternative embodiment the inspection apparatus 100 is a single-beam inspection apparatus. The electron-optical column 40 may comprise an electron source 201, a beam former array 372 (also known as a gun aperture plate, a coulomb aperture array or a pre-sub-beam-forming aperture array), a condenser lens 310, a source converter (or micro-optical array) 320, an objective lens 331, and a target 308. In an embodiment the condenser lens 310 is magnetic. The target 308 may be supported by a support on a stage. The stage may be motorized. The stage moves so that the target 308 is scanned by the incidental electrons. The electron source 201, the beam former array 372, the condenser lens 310 may be the components of an illumination apparatus comprised by the electron-optical column 40. The source converter 320 (also known as a source conversion unit), described in more detail below, and the objective lens 331 may be the components of a projection apparatus comprised by the electron-optical column 40.

The electron source 201, the beam former array 372, the condenser lens 310, the source converter 320, and the objective lens 331 are aligned with a primary electron-optical axis 304 of the electron-optical column 40. The electron source 201 may generate a primary beam 302 generally along the electron-optical axis 304 and with a source crossover (virtual or real) 301S. During operation, the electron source 201 is configured to emit electrons. The electrons are extracted or accelerated by an extractor and/or an anode to form the primary beam 302.

The beam former array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the beam former array 372. It should be understood that the description is intended to apply to an electron-optical column 40 with any number of sub-beams such as one, two or more than three. The beam former array 372, in operation, is configured to block off peripheral electrons to reduce the Coulomb effect. The Coulomb effect may enlarge the size of each of the probe spots 391, 392, 393 and therefore deteriorate inspection resolution. The beam former array 372 reduces aberrations resulting from Coulomb interactions between electrons projected in the beam. The beam former array 372 may include multiple openings for generating primary sub-beams even before the source converter 320.

The source converter 320 is configured to convert the beam (including sub-beams if present) transmitted by the beam former array 372 into the sub-beams that are projected towards the target 308. In an embodiment the source converter is a unit. Alternatively, the term source converter may be used simply as a collective term for the group of components that form the beamlets from the sub-beams.

As shown in Figure 2, in an embodiment the electron-optical column 40 comprises a beam-limiting aperture array 321 with an aperture pattern (i.e. apertures arranged in a formation) configured to define the outer dimensions of the beamlets (or sub-beams) projected towards the target 308. In an embodiment the beam-limiting aperture array 321 is part of the source converter 320. In an alternative embodiment the beam-limiting aperture array 321 is part of the system up-beam of the main column. In an embodiment, the beam-limiting aperture array 321 divides one or more of the sub-beams 311, 312, 313 into beamlets such that the number of beamlets projected towards the target 308 is greater than the number of sub-beams transmitted through the beam former array 372. In an alternative embodiment, the beam-limiting aperture array 321 keeps the number of the sub-beams incident on the beam-limiting aperture array 321, in which case the number of sub-beams may equal the number of beamlets projected towards the target 308.

As shown in Figure 2, in an embodiment the electron-optical column 40 comprises a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams 311, 312, and 313 onto the beam-limiting aperture array 321.

The electron-optical column 40 may also include an image-forming element array 322 with image-forming deflectors 322_1, 322_2, and 322_3. There is a respective deflector 322_1, 322_2, and 322_3 associated with the path of each beamlet. The deflectors 322_1, 322_2, and 322_3 are configured to deflect the paths of the beamlets towards the electron-optical axis 304. The deflected beamlets form virtual images (not shown) of source crossover 301S. In the current embodiment, these virtual images are projected onto the target 308 by the objective lens 331 and form probe spots 391, 392, 393 thereon. The electron-optical column 40 may also include an aberration compensator array 324 configured to compensate aberrations that may be present in each of the sub-beams. In an embodiment the aberration compensator array 324 comprises a lens configured to operate on a respective beamlet. The lens may take the form or an array of lenses. The lenses in the array may operate on a different beamlet of the multi-beam. The aberration compensator array 324 may, for example, include a field curvature compensator array (not shown) for example with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The source converter 320 may further comprise a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams onto the beam-limiting aperture array 321. In an embodiment, the pre-bending micro-deflector array 323 may be configured to bend the sub-beam path of sub-beams towards the orthogonal of the plane of on beam-limiting aperture array 321. In an alternative embodiment the condenser lens 310 may adjust the path direction of the sub-beams onto the beam-limiting aperture array 321. The condenser lens 310 may, for example, focus (collimate) the three sub-beams 311, 312, and 313 to become substantially parallel beams along primary electron-optical axis 304, so that the three sub-beams 311, 312, and 313 incident substantially perpendicularly onto source converter 320, which may correspond to the beam-limiting aperture array 321. In such alternative embodiment the pre-bending deflector array 323 may not be necessary.

The image-forming element array 322, the aberration compensator array 324, and the pre-bending deflector array 323 may comprise multiple layers of sub-beam manipulating devices, some of which may be in the form or arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

In the current example of the electron-optical column 40, the beamlets are respectively deflected by the deflectors 322_1, 322_2, and 322_3 of the image-forming element array 322 towards the electron-optical axis 304. It should be understood that the beamlet path may already correspond to the electron-optical axis 304 prior to reaching deflector 322_1, 322_2, and 322_3.

The objective lens 331 focuses the beamlets onto the surface of the target 308, i.e., it projects the three virtual images onto the target surface. The three images formed by three sub-beams 311 to 313 on the target surface form three probe spots 391, 392 and 393 thereon. In an embodiment the deflection angles of sub-beams 311 to 313 are adjusted to pass through or approach the front focal point of objective lens 331 to reduce or limit the off-axis aberrations of three probe spots 391 to 393. In an arrangement the objective lens 331 is magnetic. Although three beamlets are mentioned, this is by way of example only. There may be any number of beamlets.

A manipulator is configured to manipulate one or more beams of charged particles. The term manipulator encompasses a deflector, a lens and an aperture. The pre-bending deflector array 323, the aberration compensator array 324 and the image-forming element array 322 may individually or in combination with each other, be referred to as a manipulator array, because they manipulate one or more sub-beams or beamlets of charged particles. The lens and the deflectors 322_1, 322_2, and 322_3 may be referred to as manipulators because they manipulate one or more sub-beams or beamlets of charged particles.

In an embodiment a beam separator (not shown) is provided. The beam separator may be down-beam of the source converter 320. The beam separator may be, for example, a Wien filter comprising an electrostatic dipole field and a magnetic dipole field. The beam separator may be positioned between adjacent sections of shielding (described in more detail below) in the direction of the beam path. The inner surface of the shielding may be radially inward of the beam separator. Alternatively, the beam separator may be within the shielding. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So because the secondary electrons and backscattered electrons generally move in an opposite direction compared to the primary electrons, the magnetic force exerted on the secondary electrons and backscattered electrons will no longer cancel the electrostatic force and as a result the secondary electrons and backscattered electrons moving through the beam separator will be deflected away from the electron-optical axis 304.

In an embodiment a secondary column (not shown) is provided comprising detection elements for detecting corresponding secondary charged particle beams. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus and its associated electron detection device (not shown) are provided. The secondary projection apparatus and its associated electron detection device may be aligned with a secondary electron-optical axis of the secondary column. In an embodiment the beam separator is arranged to deflect the path of the secondary electron beams towards the secondary projection apparatus. The secondary projection apparatus subsequently focuses the path of secondary electron beams onto a plurality of detection regions of the electron detection device. The secondary projection apparatus and its associated electron detection device may register and generate an image of the target 308 using the secondary electrons or backscattered electrons.

In an embodiment the inspection apparatus 100 comprises a single source.

Any element or collection of elements may be replaceable or field replaceable within the electron-optical column. The one or more electron-optical components in the column, especially those that operate on sub-beams or generate sub-beams, such as aperture arrays and manipulator arrays may comprise one or more microelectromechanical systems (MEMS). The pre-bending deflector array 323 may be a MEMS. MEMS are miniaturized mechanical and electromechanical elements that are made using microfabrication techniques. In an embodiment the electron-optical column 40 comprises apertures, lenses and deflectors formed as MEMS. In an embodiment, the manipulators such as the lenses and deflectors 322_1, 322_2, and 322_3 are controllable, passively, actively, as a whole array, individually or in groups within an array, so as to control the beamlets of charged particles projected towards the target 308.

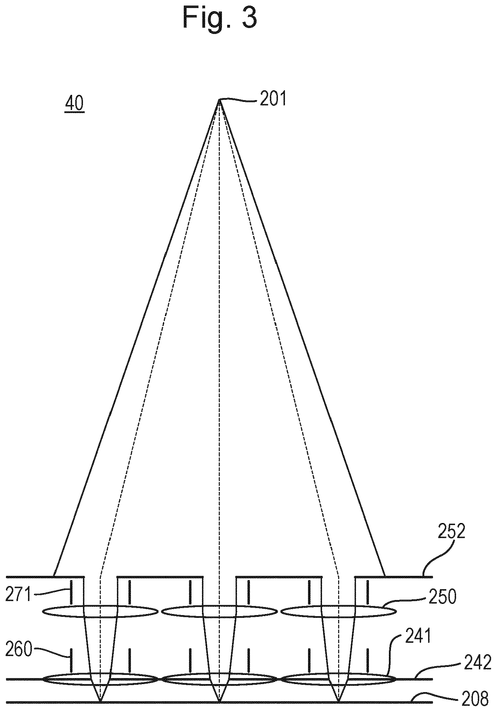

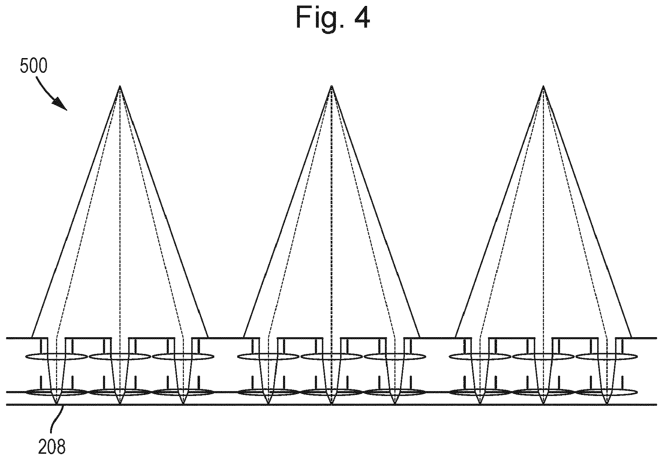

In an embodiment the electron-optical column 40 may comprise alternative and/or additional components on the charged particle path, such as lenses and other components some of which have been described earlier with reference to Figures. 1 and 2. Examples of such arrangements are shown in Figures 3 and 4 which are described in further detail later. In particular, embodiments include an electron-optical column 40 that divides a charged particle beam from a source into a plurality of sub-beams. A plurality of respective objective lenses may project the sub-beams onto a sample. In some embodiments, a plurality of condenser lenses is provided up-beam from the objective lenses. The condenser lenses focus each of the sub-beams to an intermediate focus up-beam of the objective lenses. In some embodiments, collimators are provided up-beam from the objective lenses. Correctors may be provided to reduce focus error and/or aberrations. In some embodiments, such correctors are integrated into or positioned directly adjacent to the objective lenses. Where condenser lenses are provided, such correctors may additionally, or alternatively, be integrated into, or positioned directly adjacent to, the condenser lenses and/or positioned in, or directly adjacent to, the intermediate foci. A detector is provided to detect charged particles emitted by the sample. The detector may be integrated into the objective lens. The detector may be on the bottom surface of the objective lens so as to face a sample in use. The detector may comprise an array which may correspond to the array of the beamlets of the multi-beam arrangement. The detectors in the detector array may generate detection signals that may be associated with the pixels of a generated image. The condenser lenses, objective lenses and/or detector may be formed as MEMS or CMOS devices.

Figure 3 is a schematic diagram of another design of exemplary electron-optical system. The electron-optical system may comprise a source 201 and electron-optical column. The electron optical column may comprise an upper beam limiter 252, a collimator element array 271, a control lens array 250, a scan deflector array 260, an objective lens array 241, a beam shaping limiter 242 and a detector array. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The source 201 is desirably a high brightness thermal field emitter with a good compromise between brightness and total emission current.

The upper beam limiter 252 defines an array of beam-limiting apertures. The upper beam limiter 252 may be referred to as an upper beam-limiting aperture array or up-beam beam-limiting aperture array. The upper beam limiter 252 may comprise a plate (which may be a plate-like body) having a plurality of apertures. The upper beam limiter 252 forms the sub-beams from the beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

The collimator element array 271 is provided down-beam of the upper beam limiter. Each collimator element collimates a respective sub-beam. The collimator element array 271 may be formed using MEMS manufacturing techniques so as to be spatially compact. In some embodiments, exemplified in Figure 3, the collimator element array 271 is the first deflecting or focusing electron-optical array element in the beam path down-beam of the source 201. In another arrangement, the collimator may take the form, wholly or partially, of a macro-collimator. Such a macro-collimator may be up beam of the upper beam limiter 252 so it operates on the beam from the source before generation of the multi-beam. A magnetic lens may be used as the macro-collimator.

Down-beam of the collimator element array there is the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures.

The scan-deflector array 260 comprising a plurality of scan deflectors may be provided. The scan-deflector array 260 may be formed using MEMS manufacturing techniques. Each scan deflector scans a respective sub-beam over the sample 208. The scan-deflector array 260 may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). In an embodiment, the scanning deflectors described in EP2425444, which document is hereby incorporated by reference in its entirety specifically in relation to scan deflectors, may be used to implement the scan-deflector array 260. A scan-deflector array 260 (e.g. formed using MEMS manufacturing techniques as mentioned above) may be more spatially compact than a macro scan deflector. In another arrangement, a macro scan deflector may be used up beam of the upper beam limiter 252. Its function may be similar or equivalent to the scan-deflector array although it operates on the beam from the source before the beamlets of the multi-beam are generated.

The objective lens array 241 comprising a plurality of objective lenses is provided to direct the sub-beams onto the sample 208. Each objective lens comprises at least two electrodes (e.g. two or three electrodes) connected to respective potential sources. The objective lens array 241 may comprise two or more (e.g. three) plate electrode arrays connected to respective potential sources. Each objective lens formed by the plate electrode arrays may be a micro-lens operating on a different sub-beam. Each plate defines a plurality of apertures (which may also be referred to as holes). The position of each aperture in a plate corresponds to the position of a corresponding aperture (or apertures) in the other plate (or plates). The corresponding apertures define the objective lenses and each set of corresponding apertures therefore operates in use on the same sub-beam in the multi-beam. Each objective lens projects a respective sub-beam of the multi-beam onto a sample 208.

The objective lens array may form part of an objective lens array assembly along with any or all of the scan-deflector array 260, control lens array 250 and collimator element array 271. The objective lens array assembly may further comprise the beam shaping limiter 242. The beam shaping limiter 242 defines an array of beam-limiting apertures. The beam shaping limiter 242 may be referred to as a lower beam limiter, lower beam-limiting aperture array or final beam-limiting aperture array. The beam shaping limiter 242 may comprise a plate (which may be a plate-like body) having a plurality of apertures. The beam shaping limiter 242 is down-beam from at least one electrode (optionally from all electrodes) of the control lens array 250. In some embodiments, the beam shaping limiter 242 is down-beam from at least one electrode (optionally from all electrodes) of the objective lens array 241.

In an arrangement, the beam shaping limiter 242 is structurally integrated with an electrode 302 of the objective lens array 241. Desirably, the beam shaping limiter 242 is positioned in a region of low electrostatic field strength. Each of the beam-limiting apertures is aligned with a corresponding objective lens in the objective lens array 241. The alignment is such that a portion of a sub-beam from the corresponding objective lens can pass through the beam-limiting aperture and impinge onto the sample 208. Each beam-limiting aperture has a beam limiting effect, allowing only a selected portion of the sub-beam incident onto the beam shaping limiter 242 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

In an embodiment, the electron-optical system is configured to control the objective lens array assembly (e.g. by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. The control lens array and the objective lens array operate together to for a combined focal length to the same surface. Combined operation without an intermediate focus may reduce the risk of aberrations. In other embodiments, the objective lens array assembly may be configured to form an intermediate focus between the control lens array 250 and the objective lens array 241.

An electric power source may be provided to apply respective potentials to electrodes of the control lenses of the control lens array 250 and the objective lenses of the objective lens array 241.

The provision of a control lens array 250 in addition to an objective lens array 241 provides additional degrees of freedom for controlling properties of the sub-beams. The additional freedom is provided even when the control lens array 250 and objective lens array 241 are provided relatively close together, for example such that no intermediate focus is formed between the control lens array 250 and the objective lens array 241. The control lens array 250 may be used to optimize a beam opening angle with respect to the demagnification of the beam and/or to control the beam energy delivered to the objective lens array 241. The control lens may comprise two or three or more electrodes. If there are two electrodes then the demagnification and landing energy are controlled together. If there are three or more electrodes the demagnification and landing energy can be controlled independently. The control lenses may thus be configured to adjust the demagnification and/or beam opening angle and/or the landing energy on the substrate of respective sub-beams (e.g. using the electric power source to apply suitable respective potentials to the electrodes of the control lenses and the objective lenses). This optimization can be achieved without having an excessively negative impact on the number of objective lenses and without excessively deteriorating aberrations of the objective lenses (e.g. without decreasing the strength of the objective lenses). Use of the control lens array enables the objective lens array to operate at its optimal electric field strength. Note that it is intended that the reference to demagnification and opening angle is intended to refer to variation of the same parameter. In an ideal arrangement the product of a range of demagnification and the corresponding opening angles is constant. However, the opening angle may be influenced by the use of an aperture.

In an embodiment, the landing energy can be controlled to a desired value in a predetermined range, e.g. from 1000 eV to 5000 eV. Desirably, the landing energy is primarily varied by controlling the energy of the electrons exiting the control lens. The potential differences within the objective lenses are preferably kept constant during this variation so that the electric field within the objective lens remains as high as possible. The potentials applied to the control lens in addition may be used to optimize the beam opening angle and demagnification. The control lens can function to change the demagnification in view of changes in landing energy. Desirably, each control lens comprises three electrodes so as to provide two independent control variables. For example, one of the electrodes can be used to control magnification while a different electrode can be used to independently control landing energy. Alternatively each control lens may have only two electrodes. When there are only two electrodes, one of the electrodes may need to control both magnification and landing energy.

The detector array (not shown) is provided to detect charged particles emitted from the sample 208. The detected charged particles may include any of the charged particles detected by an SEM, including secondary and/or backscattered electrons emitted from the sample 208. The detector may be an array providing the surface of the column facing the sample 208, e.g. the bottom surface of the column. Alternative the detector array be up beam of the bottom surface or example in or up beam of the objective lens array or the control lens array. The elements of the detector array may correspond to the beamlets of the multi-beam arrangement. The signal generated by detection of an electron by an element of the array be transmitted to a processor for generation of an image. The signal may correspond to a pixel of an image.

In other embodiments both a macro scan deflector and the scan-deflector array 260 are provided. In such an arrangement, the scanning of the sub-beams over the sample surface may be achieved by controlling the macro scan deflector and the scan-deflector array 260 together, preferably in synchronization.

In an embodiment, as exemplified in Figure 4, an electron-optical system array 500 is provided. The array 500 may comprise a plurality of any of the electron-optical systems described herein. Each of the electron-optical systems focuses respective multi-beams simultaneously onto different regions of the same sample. Each electron-optical system may form sub-beams from a beam of charged particles from a different respective source 201. Each respective source 201 may be one source in a plurality of sources 201. At least a subset of the plurality of sources 201 may be provided as a source array. The source array may comprise a plurality of sources 201 provided on a common substrate. The focusing of plural multi-beams simultaneously onto different regions of the same sample allows an increased area of the sample 208 to be processed (e.g. assessed) simultaneously. The electron-optical systems in the array 500 may be arranged adjacent to each other so as to project the respective multi-beams onto adjacent regions of the sample 208.

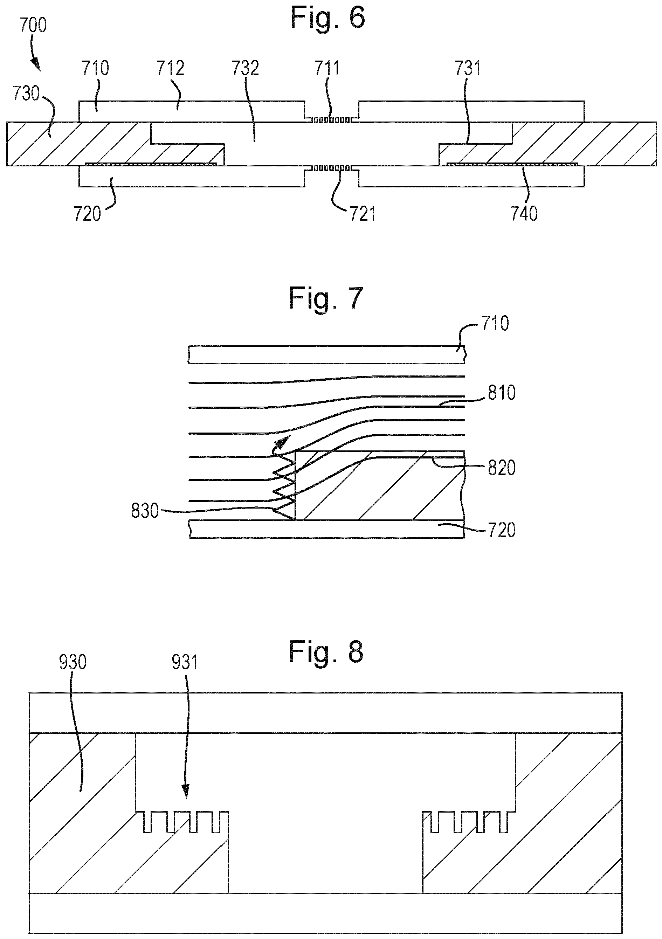

Any number of electron-optical systems may be used in the array 500. Preferably, the number of electron-optical systems is in the range of from 2 (preferably 9) to 200. In an embodiment, the electron-optical systems are arranged in a rectangular array or in a hexagonal array. In other embodiments, the electron-optical systems are provided in an irregular array or in a regular array having a geometry other than rectangular or hexagonal. Each electron-optical system in the array 500 may be configured in any of the ways described herein when referring to a single electron-optical system, for example as described above, especially with respect to the embodiment shown and described in reference to Fig 6. Details of such an arrangement is described in EPA 20184161.6 filed 6 July 2020 which, with respect to how the objective lens is incorporated and adapted for use in the multi-column arrangement is hereby incorporated by reference.

In the example of Figure 4 the array 500 comprises a plurality of electron-optical systems of the type described above with reference to Figure 3. Each of the electron-optical systems in this example thus comprise both a scan-deflector array 260 and a collimator element array 271. As mentioned above, the scan-deflector array 260 and collimator element array 271 are particularly well suited to incorporation into an electron-optical system array 500 because of their spatial compactness, which facilitates positioning of the electron-optical systems close to each other. This arrangement of electron optical column may be preferred over other arrangements that use a magnetic lens as collimator. Magnetic lenses may be challenging to incorporate into an electron-optical column intended for use in a multi-column arrangement.

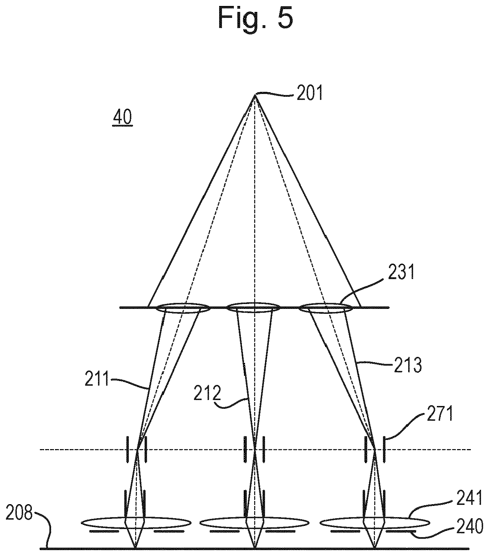

An alternative design of multi-beam electron optical column may have the same features as described with respect to Figure 3 expect as described below and illustrated in Figure 5. The alternative design of multi-beam electron optical column may comprise a condenser lens array 231 upbeam of the object lens array arrangement 241, as disclosed in EP application 20158804.3 filed on 21 February 2020 which is hereby incorporated by reference so far as the description of the multi-beam column with a collimator and its components. Such a design does not require the beam shaping limiter array 242 or the upper beam limiter array 252 because a beam limiting aperture array associated with condenser lens array 231 may shape the beamlets 211, 212, 213 of the multi-beam from the beam of the source 201. The beam limiting aperture array of the condenser lens may also function as an electrode in the lens array.

The paths of the beamlets 211, 212, 213 diverge away from the condenser lens array 231. The condenser lens array 231 focuses the generated beamlets to an intermediate focus between the condenser lens array 231 and the objective lens array assembly 241 (i.e. towards the control lens array and the objective lens array). The collimator array 271 may be at the intermediate foci instead of associated with the objective lens array assembly 241.

The collimator may reduce the divergence of the diverging beamlet paths. The collimator may collimate the diverging beamlet paths so that they are substantially parallel towards the objective lens array assembly. Corrector arrays may be present in the multi-beam path, for example associated with the condenser lens array, the intermediate foci and the objective lens array assembly. The detector 240 may be integrated into the objective lens 241. The detector 240 may be on the bottom surface of the objective lens 241 so as to face a sample in use.

An electron-optical system array may have multiple multi-beam columns of this design as described with reference to the multi-beam column of Figure 3 as shown in Figure 4. Such an arrangement is shown and described in EP Application 20158732.6 filed on 21 February 2020 which is hereby incorporated by reference with respect to the multi-column arrangement of a multi-beam tool featuring the design of multi-beam column disclosed with a collimator at an intermediate focus.

A further alternative design of multi-beam tool comprises multiple single beam columns. The single beams generated for the purposes of the invention herein described may be similar or equivalent to a multi-beam generated by a single column. Such a multi-column tool may have one hundred columns each generating a single beam or beamlet. In this further alternative design the single beam columns may have a common vacuum system, each column have a separate vacuum system or groups of columns are assigned different vacuum systems. Each column may have an associated detector.

The electron-optical column 40 may be a component of an inspection (or metro-inspection) tool or part of an e-beam lithography tool. The multi-beam charged particle apparatus may be used in a number of different applications that include electron microscopy in general, not just SEM, and lithography.

The electron-optical axis 304 describes the path of charged particles through and output from the source 201. The sub-beams and beamlets of a multi-beam may all be substantially parallel to the electron-optical axis 304 at least through the manipulators or electron -optical arrays, unless explicitly mentioned. The electron-optical axis 304 may be the same as, or different from, a mechanical axis of the electron-optical column 40.

The electron-optical column 40 may comprise an electron-optical device 700 as shown in Figure 6 for manipulating electron beamlets. For example, the objective lens array 241, and/or the condenser lens array 231 may comprise the electron optical device 700. In particular, the objective lens 331 and/or the condenser lens 310 and/or the control lens 250 may comprise the electron optical device 700.

The electron-optical device is configured to provide a potential difference between two or more substrates. An electrostatic field is generated between the substrates, which act as electrodes. The electrostatic field results in an attraction force between the two substrates. The attraction force may be increased with increasing potential difference.

In the electron-optical device, at least one of the substrates has a thickness which is stepped such that the array substrate is thinner in the region corresponding to the array of apertures than another region of the array substrate. It is advantageous to have a stepped thickness, for example with two portions of the substrate having different thicknesses, because at high potential differences the substrate is subjected to higher electrostatic forces which can result in bending if the substrate were a consistent thickness and, for example, too thin. Bending of the substrate can adversely affect beam-to-beam uniformity. Thus, a thick substrate is advantageous to mitigate bending. However, if the substrate is too thick in the region of the array of apertures, it can result in undesirable electron beamlet deformation. Thus, a thin substrate around the array of apertures is advantageous to mitigate electron beamlet deformation. That is in a region of the substrate thinner than the rest of the substrate the array of apertures may be defined. The stepped thickness of the substrate thus reduces the likelihood of bending, without increasing the likelihood of beamlet deformation.

The exemplary electron-optical device shown in Figure 6 comprises an array substrate 710, an adjoining substrate 720 and a spacer 730. (Note the term 'array substrate' is a term used to different the substrate from other substrates referred to in the description). In the array substrate, an array of apertures 711 is defined for the path of electron beamlets. The number of apertures in the array of apertures may correspond to the number of sub-beams in the multi-beam arrangement. In one arrangement there are fewer apertures than sub-beams in the multi-beam so that groups of sub-beam paths pass through an aperture. For example an aperture may extend across the multi-beam path; the aperture may be a strip or slit. The spacer 730 is disposed between the substrates to separate the substrates. The electron-optical device is configured to provide a potential difference between the array substrate 710 and the adjoining substrate 720.

In the adjoining substrate 720, another array of apertures 721 is defined for the path of the electron beamlets. The adjoining substrate 720 may also have a thickness which is stepped such that the adjoining substrate is thinner in the region corresponding to the array of apertures than another region of the adjoining substrate. Preferably, the array of apertures 721 defined in the adjoining substrate 720 has the same pattern as the array of apertures 711 defined in the array substrate 710. In an arrangement the pattern of the array of apertures in the two substrates may be different. For example, the number of apertures in the adjoining substrate 720 may be fewer or greater than the number of apertures in the array substrate 710. In an arrangement there is a single aperture in the adjoining substrate for all the paths of the sub-beams of the multi-beam. Preferably the apertures in the array substrate 710 and the adjoining substrate 720, are substantially mutually well aligned. This alignment between the apertures is in order to limit lens aberrations

The array substrate and the adjoining substrate may each have a thickness of up to 1.5 mm at the thickest point of the substrate, preferably 1 mm, more preferably 500 µm. In an arrangement, the downbeam substrate (i.e., the substrate closer to the sample) may have a thickness of between 200 µm and 300 µm at its thickest point. The downbeam substrate preferably a thickness of between 200 µm and 150 µm at its thickest point. The upbeam substrate (i.e., the substrate farther from the sample) may have a thickness of up to 500 µm at its thickest point.

A surface of the array substrate between the thinner region of the substrate 710 and the other region, e.g. the thicker region, of the substrate, for example that provides the step is preferably orthogonal to the surface of the substrate facing the adjoining substrate 720 and/or the path of the multi-beam. Similarly, a surface of the adjoining substrate 720 at the step between the thicker region (radially outward) and the inner region (radially inward) may preferably be orthogonal to the surface of the adjoining substrate facing the array substrate 710.

A coating may be provided on a surface of the array substrate and/or the adjoining substrate. Preferably both the coating is provided on the array substrate and the adjoining substrate. The coating reduces surface charging which otherwise can result in unwanted beam distortion.

The coating is configured to survive a possible electric breakdown event between the array substrate and the adjoining substrate. Preferably, a low ohmic coating is provided, and more preferably a coating of 0.5 Ohms/square or lower is provided. The coating is preferably provided on the surface of the downbeam substrate. The coating is more preferably provided between at least one of the substrates and the spacer. The low ohmic coating reduces undesirable surface charging of the substrate.

The array substrate and/or the adjoining substrate may comprise a low bulk resistance material, preferably a material of 1 Ohm.m or lower. More preferably, the array substrate and/or the adjoining substrate comprises doped silicon. Substrates having a low bulk resistance have the advantage that they are less likely to fail because the discharge current is supplied/drained via the bulk and not, for example, via the thin coating layer.

The array substrate comprises a first wafer. The first wafer may be etched to generate the regions having different thicknesses. The first wafer may be etched in the region corresponding to the array of apertures, such that the array substrate is thinner in the region corresponding to the array of apertures. For example, a first side of a wafer may be etched or both sides of the wafer may be etched to create the stepped thickness of the substrate. The etching may be by deep reactive ion etching. Alternatively or additionally, the stepped thickness of the substrate may be produced by laser-drilling or machining.

Alternatively, the array substrate may comprise a first wafer and a second wafer. The aperture array may be defined in the first wafer. The first wafer may be disposed in contact with the spacer. A second wafer disposed on a surface of the first wafer in a region not corresponding to the aperture array. The first wafer and the second wafer may be joined by wafer bonding. The thickness of the array substrate in the region corresponding to the array of apertures may be the thickness of the first wafer. The thickness of the array substrate in another region, other than the region of the array of apertures, for example radially outward of the aperture array, may be the combined thickness of the first wafer and the second wafer. Thus, the array substrate has a stepped thickness between the first wafer and the second wafer.

One of the array substrate and the adjoining substrate is upbeam of the other. One of the array substrate and the adjoining substrate is negatively charged with respect to the other substrate. Preferably the upbeam substrate has a higher potential than the downbeam substrate with respect to for example to a ground potential, the source or of the sample. The electron-optical device may be configured to provide a potential difference of 5 kV or greater between the array substrate and the adjoining substrate. Preferably, the potential difference is 10 kV or greater. More preferably, the potential different is 20 kV or greater.

The spacer 730 is preferably disposed between the array substrate and the adjoining substrate such that the opposing surfaces of the substrates are co-planar with each other. The spacer 730 has an inner surface 731 facing the path of the beamlets. The spacer 730 defines an opening 732, for the path of the electron beamlets.

A conductive coating may be applied to the spacer, for example coating 740. Preferably, a low ohmic coating is provided, and more preferably a coating of 0.5 Ohms/square or lower is provided.

The coating is preferably on the surface of the space facing the negatively charged substrate, which is negatively charged with respect to the other substrate. The downbeam substrate is preferably negatively charged with respect to the upbeam substrate. The coating shall be put at the same electric potential as the negatively charged substrate. The coating is preferably on the surface of the spacer facing the negatively charged substrate. The coating is more preferably electrically connected to the negatively charged substrate. The coating can be used to fill any possible voids in between the spacer and the negatively charged substrate.

In absence of such a coating on the spacer, electric field enhancement may occur in those voids. This electric field enhancement can result in electric breakdown in these voids and thereby in electric potential instability of the lower electrode. This potential instability results in varying lens strength over time, thereby defocusing the electron beams.

The inner surface 731 is shaped such that a creep path between the substrates over the inner surface is longer than a minimum distance between the substrates. Preferably, the inner surface of the spacer is shaped to provide a creep length of 10 kV/mm or less, preferably 3 kV/mm or less.

The exemplary electron-optical device 700 of Figure 6 comprises a spacer 730 defining an opening 732. The spacer 730 has a stepped thickness. The thickness of the spacer 730 in the region of the spacer closest to the path of the electron beamlets is less than the thickness of the spacer 730 in a region further from the path of the electron beamlets. In an arrangement, for example as depicted in Figure 6, the opening 732 of the spacer 730 has a larger width, which may be a diameter, on an upbeam side than on a downbeam side. That is in the spacer is defined an aperture or opening which may define a through passage having a surface. The through passage may have at least two different diameters at different positions along the beam path through the aperture. A stepped surface, for example between portions of the through passage having different diameters, is angled and preferably parallel to at least one of the array substrate and the adjoining substrate and/or orthogonal to the beam path. The spacer 730 has a larger surface area in contact with the downbeam substrate 720 than the surface area in contact with the upbeam substrate 710. In another arrangement, the opening defined in the spacer has a larger width on a downbeam side of the spacer than its upbeam side. One of the upbeam substrate and the downbeam substrate is positively charged with respect to the other substrate. Preferably, the opening defined in the spacer has a larger width the side of the spacer closest to the substrate which is positively charged with respect to the other substrate.

Figure 7 illustrates the electrostatic-field around the step on the inner surface 731 of the spacer 730, between the array substrate 710 and the adjoining substrate 720. In this example, the adjoining substrate 720 is downbeam of the array substrate 710. The electron-optical device, the relative permittivity εᵣ in the region between the inner surface 731 of the spacer 730 and the array substrate is approximately 1. Various materials can be used to make the spacer, such as ceramic and glass. Due to the stepped spacer 730, the relative permittivity εᵣ of the structure is increased so it is greater than 1, preferably for example 5, in the region 820 of the spacer. The stepped spacer shape is therefore advantageous because it reduces electrostatic-field strength near the 'triple point' 830 on the downbeam substrate 720, for example the location on the down-beam substrate where the down-beam substrate and the innermost inner-surface of the spacer meet. The downbeam substrate 720 has a smaller potential relative to the sample than the upbeam substrate 710. The reduction of electrostatic-field strength near the triple point 830 helps in reducing the occurrence of discharge events.

In having a lower potential difference to the sample, the downbeam substrate is negatively charged relative to the upbeam substrate. In effect, in being negatively charged relative to the upbeam substrate, the down-beam substrate supplies electrodes in the event of a discharge, for example from the triple point. In an arrangement in which the opening defined in the spacer 730 has a larger width on a downbeam side of the spacer than its upbeam side, the same description applies, except: the upbeam substrate 710 has a smaller potential difference relative to the sample than the downbeam substrate 720; and the 'triple point' 830 is on the upbeam substrate 710, for example the location on the up-beam substrate where the upbeam substrate and the innermost inner-surface of the spacer meet

In addition, the stepped inner surface 731 of the spacer 730 increases the path length for surface creep discharges as compared to a straight-wall spacer. The shortest path over the surface of the through passage may be longer in being stepped for example in having the stepped surface. In extending or lengthening the shortest path, the creep length may be extended.

As illustrated in Figure 8, the inner surface 931 of the spacer 930, for example at least part of the stepped surface, may comprise trenches to form or define corrugations. The corrugations may surround the opening. Preferably, the corrugations are concentric. The creep length is therefore further increased, for example by increasing the shortest path length over the inner surface 931, by providing a corrugated shape to the inner surface of the spacer. The presence of a corrugated position as part of the inner surface 931 thus reduces the likelihood of unwanted discharges across the substrates, for example between the upbeam substrate and downbeam substrate.

The spacer may have a thickness of between 0.1 and 2 mm at its thickest point. Preferably, the spacer has a thickness of between 0.5 and 1.6 mm, more preferably between 0.8 to 1.6 mm.

The spacer is configured to limit electron beam distortion which may be caused by charging spacer surfaces, for example charge building up or collecting with time on the inner surface 931. The charge build-up may be limited by the distance between the path of the outermost electron beamlets and the inner surfaces of the spacer, facing the path of the electron beamlets. In spacer design, the distance between the path of the electron beamlets and the inner surfaces of the spacer should be increased with increasing thickness of the spacer. The opening in the spacer results in an unsupported area of the array substrate and the adjoining substrate. The larger the unsupported area, the greater the bending of the substrates. Bending of the substrates can cause unwanted beam-to-beam lens strength variation. However, if the opening in the spacer is small, distortions can be caused by surface charging of the spacer. Therefore, it is necessary to provide a spacer with an appropriately sized opening. The opening should be small enough to limit substrate bending but large enough to reduce the likelihood of surface charging of the spacer.

As described above, the spacer has a stepped thickness such that the opening defined in the spacer has a larger width on one side and a smaller width on another side. The inner surface is preferably stepped with an upper beam portion distanced further away from the path of the beamlets than a lower beam portion. In this arrangement, the opening has the smaller width on the lower beam portion of the inner surface of the opening in the spacer.

The smaller width of the opening in the spacer may have a largest dimension of between 4 and 30 mm, preferably between 4 mm and 25 mm, more preferably between 8 mm and 20 mm, yet more preferably between 10 mm and 20 mm. Preferably, the largest dimension is a diameter.

The thickness of the spacer may be dependent on the intended potential difference applied between the substrates, i.e. the potential difference between each of the substrates and the sample and/or a ground or reference potential. Thus with increased or even elevated applied potentials, the spacer and/or the substrates (e.g. the array substrate and the adjoining substrate) should preferably become thicker. Furthermore, as discussed above, the diameter of the opening is increased with increasing thickness of the spacer. Therefore, area of the array substrate and/or the adjoining substrate which is unsupported by the spacer is increased. This is because the spacer does not contact the substrates in the area of the opening. Thus, the likelihood of substrate bending is increased due to the increased diameter of the opening. Further, during operation the applied potentials generate an electrostatic field between the upbeam substrate and down-beam substrate, The field generates an attractive force between the substrate. Consequently, to avoid bending the field may be reduced for example by reducing the potential difference between the electrodes. Alternatively or additionally the diameter of the opening is reduced to increase the rigidity of the support of the electrodes. Therefore there is optimization of the diameter of the opening in view of the bending of the electrodes and the proximity of the spacer to the sub-beams which would distort the sub-beams.

The electron-optical device may be provided in a lens assembly for manipulating electron beamlets. The lens assembly may, for example, be, or may be part of, an objective lens assembly or a condenser lens assembly. The lens assembly, such as an objective lens assembly, may further comprise an additional lens array comprising at least two substrates such as a control lens array.

The lens assembly may comprise a protective resistor 610. The protective resistor may be located in electrical routing, such as a power line, connecting a substrate, such as the upbeam or downbeam substrate, to a power source. The electrical routing may provide a potential to the substrate. The protective resistor 610 may be configured to provide controlled discharge in the lens of capacitance in a power line. The protective resistor 610 therefore prevents damage to the lens assembly.

Further, in a lens assembly, signal communication may be provided to enable data transport to and from the lens assembly specifically elements of the lens assembly such as a substrate, e.g. the upbeam substrate or the downbeam substrate, or a detector. The detector may be a detector array.

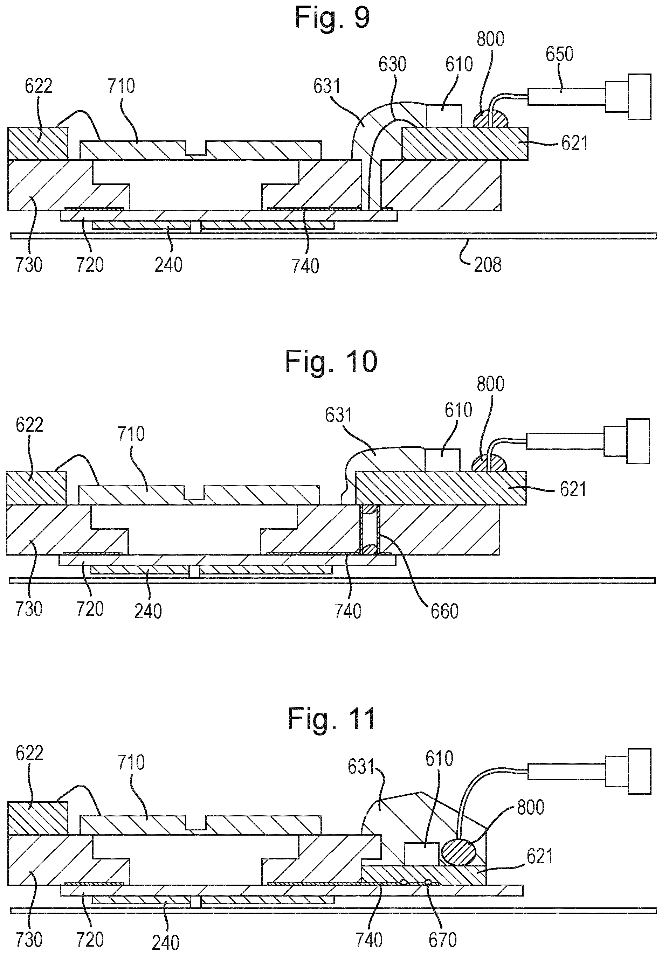

Figures 9, 10 and 11 show exemplary lens assemblies for manipulating electron beamlets, comprising an array substrate 710, an adjoining substrate 720, and a protective resistor 610. The lens assembly is configured to provide a potential difference between the substrates for example with a spacer. The array substrate 710, the adjoining substrate 720 and the spacer 730 may take the form, structure and arrangement described with reference to and depicted in Figures 6, 7 and 8 . An array of apertures is defined in the array substrate 710 for the path of electron beamlets. At least an aperture is defined in the adjoining substrate 720 for the path of the electron beamlets. The adjoining substrate 720 is disposed downbeam of the array substrate 710. The array substrate and/or the adjoining substrate may have a stepped thickness. The protective resistor 610 is configured to provide controlled discharge in the lens of capacitance in a power line.

The protective resistor is preferably electrically connected to a circuit board. There may be a circuit board electrically connected to the adjoining substrate and/or there may be a circuit board electrically connected to the array substrate. The circuit board preferably comprises a ceramic material. The circuit board preferably comprises a material, such as a ceramic, having good dielectric strength and thermal conductance with low outgassing in the vacuum environment. The lens assembly may comprises a connector configured to electrically connect the array substrate and/or the adjoining substrate to the circuit board. In an arrangement the protective substrate may be in, for example as an integral element of, the circuit board.

The lens assemblies of Figures 9, 10 and 11 comprise a first circuit board 621 electrically connected to the adjoining substrate 720 for example via connector 630. The lens assemblies further comprise a second circuit board 622 electrically connected to the array substrate 710 for example by a connector such as a connecting wire. A high voltage cable 650 is electrically connected to the first circuit board 621. The connection may be made using connection material 800, such as solder. The cable 650 provides a means of applying a potential to the substrate, for example the adjoining substrate 720. In certain designs the potential may be applied to the whole substrate, to different elements in the substrate with different potentials and dynamically either to the whole substrate or elements within the substrate. The second circuit board 622 and the upbeam substrate 710 may be connected to the high voltage cable 650. The cable 650 may in addition transmit data to and/or from the lens assembly.

The exemplary lens assembly of Figure 9, comprises a connector 630 to electrically connect the adjoining substrate 720 to the first circuit board 621. The connector 630 is surrounded by electrically insulating material 631. The insulating material 631 may have a dielectric strength of 25 kV/mm or greater, preferably 100 kV/mm or greater, and more preferably 200 kV/mm or greater. The use of electrically insulating material reduces the occurrence of discharge events.

The connector 630 may be a wire and may form a wire bond connection. The spacer 730 may define a connection opening through which the connector 630 can pass, for example to connect to the adjoining or downbeam substrate. Thus, the first circuit board 621 and/or the protective resistor 610 may be provided on an opposite side of the spacer 730 than the adjoining substrate 720. The insulating material 631 may fill the connector opening in the spacer 730. In an arrangement the protective resistor may be in, for example as an integral element of, the first circuit board.

In the exemplary lens assemblies of Figures 10 and 11, the components of the depicted lens assemblies are similar to that of Figure 9 expect as herein described. The insulating material 631 is disposed in contact with the protective resistor 610 and the first circuit board 621. Optionally, the protective resistor and/or the circuit board may be encapsulated in the insulating material 631, such that the protective resistor and/or the circuit board are not exposed to the vacuum. The insulating material 631 may prevent emission of electrons from the encapsulated surfaces of the electronic and electrical components such as the connector 630, protective resistor 610 and/or the circuit board 621. The insulating material may reduce the field generated at the conductor which may otherwise hinder the performance of the electrical components. The insulating material may cover and optionally encapsulate as much or as little of any of the electrical conductors for example as depicted in these figures. The use of electrically insulating material reduces the occurrence of discharge events.

The exemplary lens assembly of Figure 10, comprises a spacer 730 defining a connection through passage, also referred to as a via, extending between openings in the upbeam and downbeam surfaces. The connection through passage extends between the adjoining substrate 730 and the first circuit board 621. The surface of the through passage is coated with an electrically conductive coating 660. The conductive coating 660 electrically connects the adjoining substrate 720 to the first circuit board 621. Such a connection may be termed a 'via'. The conductive coating 660 may be a metal coating. This configuration has the benefit that there are no exposed sharp edges or thin wirebond wires. Thus there is a reduced likelihood of unwanted electrical discharge.

The connection through passage may be filled at least at the openings an electrically conductive filler such as conductive glue. The conductive filler may provide the electrical connection. The electrically conductive filler may be provided in addition to, or instead of the conductive coating. Alternatively or additionally, a metal object may be disposed within the connection opening to provide an electrical connection between the substrate and the circuit board.

In the exemplary lens assembly of Figure 11, the first circuit board is located next to the spacer 730. The downbeam facing surface of the spacer and the circuit board may be in a similar plane. The downbeam facing surface of the spacer and the circuit board may be in contact with the adjoining substrate 720. The first circuit board 621 is electrically connected to the adjoining substrate 720 via a flip chip connection. With this configuration, a connection opening through the spacer 730, as seen in the configurations of Figures 9 and 10, is not required. Similarly, a flip chip connection could be used to electrically connect the array substrate to the first circuit board 621 or the second circuit board 622. The flip chip connection may connect electrical contacts of the downbeam surface of the first circuit board 621 with electrical contacts of the upbeam surface of the adjoining substrate. The flip chip connection may comprise a ball grid array 670 for example to interconnect the electrical contacts of the downbeam surface of the first circuit board 621 and the upbeam surface of the adjoining substrate720. The flip chip connection may comprise through silicon vias. The through silicon vias may extend through the circuit board. The through silicon via may electrically connect at one end with a circuit on the upbeam side of the circuit board, i.e. the side in which the components on the board may be located. At the other end the through silicon vias provide electrical contacts on a downbeam facing surface of the circuit board.

Although Figures 9, 10 and 11 show objective lens assemblies, these features may be comprised in a condenser lens assembly. Such a condenser lens assembly may feature a condenser lens array 231 as shown in and described with respect to Figure 5. The condenser lens assembly is an example of a lens assembly which may be designed without the volume constraint of the arrangements depicted by and described with respect to Figures 9, 10 and 11. The condenser lens array may be configured to generate the electron beamlets from an electron beam emitted by a source. Preferably the array of apertures defined in the substrate generates the electron beamlets. The condenser lens assembly may comprise a protective resistor configured to provide controlled discharge in the lens of capacitance in a power line. The condenser lens assembly may comprise an electron-optical device, such as that shown in Figure 6. The array substrate and/or the array of apertures defined in the adjoining substrate may generate the electron beamlets for example from a beam provided by a source. The array substrate and the adjoining substrate may each have a thickness of up to 1.5 mm at the thickest point of the substrate, preferably 1 mm, more preferably 700 µm, yet more preferably 500 µm. Note that features such as the adjoining substrate 720 may take larger dimensions such as in thickness if the volume in the electron-optical design so provides.

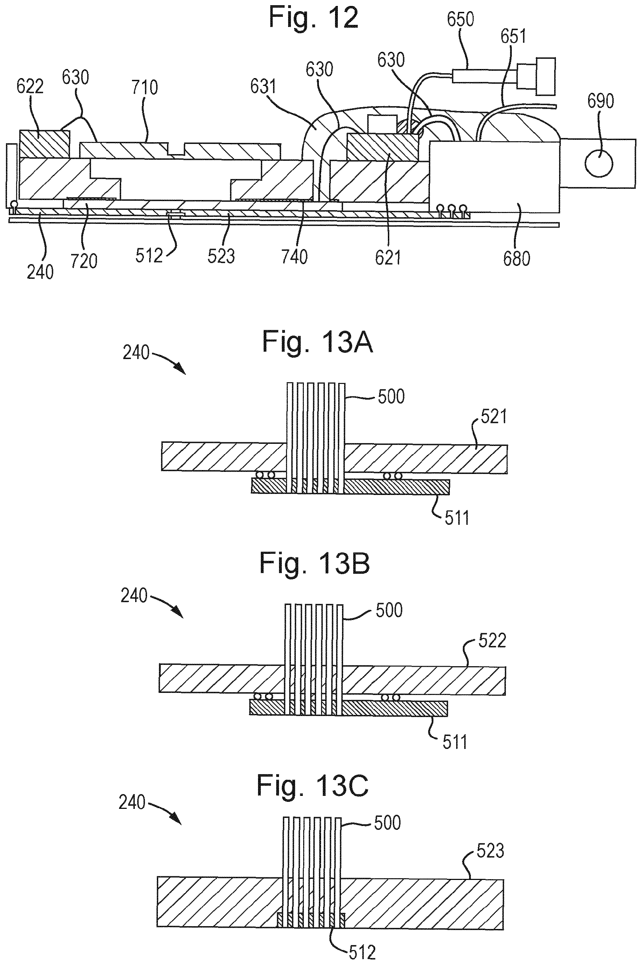

The lens assembly may be an objective lens assembly, for example as shown in Figure 12. The objective lens assembly, like that of the arrangements shown in Figures 9, 10 and 11, may comprise a detector 240 downbeam of the electron-optical device. The detector may be comprised in a detector assembly. The detector may comprise silicon and preferably the detector substantially comprises silicon. The detector may comprises a detector array, for example of detector elements, configured to detect electrons emitted from the sample. A detector element may be associated with each sub-beam path. The detector array may take the form and function of the detector array described and depicted in 2019P00407EP filed in July 2020, hereby incorporated by reference with respect the form of the detector array, Preferably at least portion of the detector is adjacent to and/or integrated with the objective lens array; for example the detector array be adjacent or integral to the adjoining substrate 730.

In the arrangements depicted in Figures 9 to 11, the detector array is electrically connected via the adjoining substrate. Thus the detector array is signally connected via the adjoining substrate. The detector array may therefore be connected via the first circuit board 621 (which may be ceramic), the connection 630, the cable 650, the via 660, and a flip chip connection.

In the arrangement depicted in Figure 12 the detector assembly may comprise a detection circuit board 680. The detection circuit board 680 is electrically connected to the detector array. The detection circuit board may be electrically connected to the detector array via a flip chip connection. The flip chip connection may comprise a ball grid array. The flip chip connection may comprise through silicon vias. The features of the flip chip connection and through silicon vias may be as described with respect to the flip chip connection and through silicon vias as described with respect to Figure 11. In Figure 12, each of the adjoining substrate 720 is electrically connected to the first circuit board 621 and the detector array is connected to the detection circuit board 680. Alternatively, one of the circuit boards may be electrically connected to both the adjoining substrate and detector array. Similarly, in figure 12 the second circuit board 622 is electrically connected to the array substrate 710. Alternatively, the array substrate may be electrically connected to the same circuit board that the adjoining substrate and/or the detector array is electrically connected to.

The detector assembly may comprise ceramic. Preferably the detector assembly comprises a ceramic material in the detection circuit board. More preferably the detection circuit board comprises a ceramic circuit board. The lens assembly, such as an objective lens assembly may be thermally conditioned. Thus elements of the objective lens assembly such as the upbeam substrate, the downbeam substrate and the detection assembly may be thermally conditioned. Thus the detector and the detection circuit board may be thermally conditioned. Preferably, thermal conditioning may be achieved actively by cooling. Thus, the detection circuit board may be actively cooled. If the detection circuit comprises a ceramic, cooling of the detection circuit can also cool other parts of the objective lens assembly through the thermal conductance of elements of the objective lens assembly comprising materials of high thermal conductivity such as ceramic. Other parts of the objective lens assembly which may be cooled include the detector assembly, one or both of the array substrate and the adjoining substrate. The first and second circuit boards may be cooled directly or indirectly by thermal conditioning for example by direct or indirect contact with a cooling system. The first and second printed circuit boards may be suited to thermal conditioning because they may each comprise ceramic material (thereby facilitate the thermal conditioning and thus cooling). In cooling the detector assembly the detector and its detector elements may be cooled due to thermal conductivity through the detection circuit, board. In another arrangement the detector is actively cooled in addition or in alternate to the active thermal conditioning of the detection circuit board by for example contact with a cooling system.

Connections to transmit signals to or from the detector may be provided via electrical connection or glass fiber for data transport. By being electrically insulating, a glass fibre connection enables detector control and data processing at ground potential. Thus, less insulation material is required for signal communication via glass fiber than via an electrical connection. For example, a glass fiber connection may be provided to transport data to/from the detection circuit. An opto-coupler may be provided to transport signals from the detection circuit board. The opto-coupler may be fitted to the detection circuit board for connection to an optical fiber, for example a glass fiber.

The detector may comprise a readout chip. An opening for the path of the electron beamlets may be defined in the readout chip. Preferably the opening is an array of openings. More preferably the array of openings corresponds to the array aperture array defined in the array substrate. Each of the openings in the readout chip preferably corresponds to the path of at least one electron beamlet.

The readout chip may be provided in contact with a substrate which may be the downbeam substrate of the array substrate and the adjoining substrate. In another arrangement the read-out chip may be mounted to or integral with the detection circuit board. In the arrangements described, the downbeam substrate is the adjacent substrate. The readout chip may provide additional strength, for example rigidity, to the downbeam substrate which may further reduce the likelihood of unwanted bending of the substrate.

In the exemplary detectors 240 of Figures 13A and 13B, the detector array 511 is disposed down beam of the readout chip 521. The detector array 511 may be electrically connected to the readout chip via a flip chip connection. The flip chip connection may have the features such as through vias, electrical contacts and a ball grid array as described with respect to Figures 11 and 12. In Fig 13A defined in the readout chip 521 is defined an aperture dimensioned for the path of the entire multi-beam. The aperture array in the detector array is aligned with the single aperture in the readout chip 521.

In Figure 13B, defined in the readout chip 522 are a plurality of apertures. The aperture may have a pattern corresponding to the pattern of the aperture array defined in the detector array 511. Alternatively, the apertures in the readout chip may correspond to the path of two or more sub-beams and thus two or more apertures of the detector array 511.

In the exemplary detector assembly of Figure 13C, the detector array 512 is within the readout chip 523. The detector array 512 is downbeam of the at least one opening in the readout chip 523. The detector array 512 provides a downbeam surface of the readout chip 523. In an alternative arrangement, the detector array could be disposed within, for example integrated into, the readout chip such that the readout chip is upbeam and downbeam of the detector array.

The detector 240 may be comprised in a lens assembly 241. The lens assembly may further comprise a cooling circuit configured to thermally condition the lens assembly. Preferably the cooling circuit is in thermal contact with the detector. More preferably in thermal communication with the detection circuit board and thus the detector array. Active or passive cooling may be provided to thermally condition the lens assembly. Cooling may be provided as a water cooling system. The water cooling system may be provided either at ground or at high voltage. If the water is provided at high voltage then the water is preferably de-ionized. Water conducts electricity and the use of regular water will result in discharging. A description of providing thermal conditioning to an array of electron-optical elements in an electron-optical column preferably towards the downbeam end of the column is provided in US20180113386A1 and US2012/0292524 both of which are hereby incorporated by reference with respect to the disclosure of cooling systems and structures in an electron-optical array.

Preferably, the readout chip 523 separated from the adjoining substrate 720 by a narrow gap. Due to the vacuum, the readout chip 523 and the adjoining substrate are thermally isolated, e.g. not in thermal contact. That is the readout chip 523, for example and the adjoining substrate are spaced apart. As the readout chip 253 is part of the detector 240 which in turn comprises detector array 512 , the detector 240 and/or detector array 512 may be spaced part from the adjoining substrate 720 for example by a narrow gap. Depending on the specific arrangement, the detector 240 and/or detector array 512 are thermally isolated from the adjoining substrate. Thus, any heat dissipating from the detector does not transfer to the adjoining substrate 720. The substrates have more stringent thermal stability requirements than the detector, therefore it is preferable not to overheat the substrates.

The exemplary objective lens of Figure 12 comprises a detector array 512, a readout chip 523, a detection circuit board 680, an optic fiber 651 and a cooling system 690. The cooling system may take the form of an active thermal conditioning system. The detector array is connected to the detection circuit board 680 via a flip chip connection between the readout chip 513 and the detection circuit board 680. The detection circuit board 680 is cooled by the cooling system 690. The cooling system 690 may be a conduit which is thermal connection through thermal conductive elements of the objective lens assembly such as the detector array 512. The detection circuit board may be in thermal connection with the cooling circuit and a carrier substrate into which the read-out chip and detector array may be comprised is connected to the detection circuit board. As depicted the cooling conduit is positioned in contact with the detection circuit board away from the multi-beam path. Thus the detection circuit board 680 preferably comprises ceramic such that the readout chip 513 is cooled by the thermal conductivity of the detection circuit board 680. The conduit of the cooling system 690 at the ground potential or a reference potential. In another arrangement the cooling circuit is at high potential. In such an arrangement the conduit may be positioned in thermal contact with the detection circuit board 621. The location of the conduit may be more proximate to the multi-beam path. Having the cooling circuit at high voltages means less high voltage isolation would be required on the circuit board. As a consequence the lens arrangement may fill less space. Thus the water cooling conduit can be positioned closer to the active electronics that dissipates more heat, for example the detector array and the objective lens assembly. As noted other features of the objective lens assembly, or indeed a lens assembly, embodying an aspect of the invention may feature a cooling system, such as system shown and described with respect to **FIG.** 12, for example cooling system 690.

The detection circuit board 680 is configured to transmit and/or receive signal communication via the optic fiber 651. The downbeam substrate 740 is in electrical connection with the first circuit board 621 via an insulated wire 630. Thus, the objective lens has signal communication via the optic fiber 651, in connection with the detector array 512, and via the cable 650, in connection with the downbeam substrate 740.

The detector may form part of an election-optical column, such as the electron-optical column 40 of any of Figures 1 to 5. The electron-optical column may be configured to generate beamlets from a source beam and to project the beamlets towards a sample. The detector may be disposed facing the sample and be configured to detect electrons emitted from the sample. The detector may comprise an array of current detectors. Signal communication to the detector array may comprise signal communication via optic fiber which may be comprised in the objective lens assembly. An electron-optical system may comprise the electron-optical column. The electron-optical system also comprising a source configured to emit an electron beam.

A plurality of electron-optical systems may be comprised in an electron-optical system array. The electron-optical systems of the electron-optical system array are preferably be configured to focus respective multi-beams simultaneously onto different regions of the same sample.

Embodiments of the invention are set out in the following numbered clauses:
Clause 1: An electron-optical device for manipulating electron beamlets, the device comprising: an array substrate in which an array of apertures is defined for the path of electron beamlets, the substrate having a thickness which is stepped so that the array substrate is thinner in the region corresponding to the array of apertures than another region of the array substrate; and an adjoining substrate in which at least an aperture, and preferably another array of apertures, is defined for the path of the electron beamlets; wherein the electron-optical device is configured to provide a potential difference between the substrates.
Clause 2: The electron-optical device according to clause 1, wherein one of the array substrate and the adjoining substrate is upbeam of the other and preferably the upbeam substrate has a higher potential difference than the downbeam substrate.
Clause 3: The electron-optical device according to clause 2, wherein the downbeam substrate has a thickness of between 200 µm and 300 µm at its thickest point.
Clause 4: The electron-optical device according to any one of clauses 1 to 3, wherein the potential difference is 5 kV or greater.
Clause 5: The electron-optical device according to any one of clauses 1 to 4 wherein a surface of the substrate between the thinner region of the substrate and the other region of the substrate is orthogonal to the surface of the substrate facing the adjoining substrate.
Clause 6: The electron-optical device according to any one of clauses 1 to 5, further comprising a spacer disposed between the substrates to separate the substrates such that the opposing surfaces of the substrates are co-planar with each other, the spacer having an inner surface facing the path of the beamlets.
Clause 7: The electron-optical device according to clause 6, wherein the spacer defines an opening, for the path of the electron beamlets.
Clause 8: The electron-optical device according to either of clauses 6 and 7, wherein the inner surface is shaped such that a creep path between the substrates over the inner surface is longer than a minimum distance between the substrates.
Clause 9: The electron-optical device according to clause 8, wherein the inner surface comprises corrugations, preferably the corrugations are concentric and/or the corrugations surround the opening.
Clause 10: The electron-optical device according to any one of clauses 6 to 8, wherein the array substrate comprises a first wafer in which an aperture array is defined, disposed in contact with the spacer; and a second wafer disposed on a surface of the first wafer in a region not corresponding to the aperture array.
Clause 11: The electron-optical device according to any one of clauses 1 to 9, wherein the array substrate comprises a first wafer etched to generate the regions having different thicknesses.
Clause 12: The electron-optical device according to any one of clauses 6 to 11, wherein the inner surface is stepped with an upper beam portion distanced further away from the path of the beamlets than a lower beam portion.
Clause 13: The electron-optical device according to clause 12, wherein the opening in the lower beam portion of the inner surface of the opening in the spacer has a largest dimension, preferably diameter, of between 4 and 30 mm.
Clause 14:The electron-optical device according to any one of clauses 6 to 13, wherein the spacer has a thickness of between 0.1 and 2 mm at its thickest point.
Clause 15: The electron-optical device according any one of clauses 1 to 14, wherein a coating of 0.5 Ohms/square or lower is provided on the surface of at least one of the substrates.
Clause 16: The electron-optical device according any one of clauses 1 to 15, wherein at least one of the substrates comprises a material of 1 Ohm.m or lower.
Clause 17: The electron-optical device according to any one of clauses 1 to 16, wherein at least one of the substrates comprises doped silicon.
Clause 18: The electron-optical device according to any one of clauses 1 to 17, wherein the array of apertures defined in the adjoining substrate has the same pattern as the array of apertures defined in the array substrate.
Clause 19: A lens assembly for manipulating electron beamlets, comprising the electron-optical device of any preceding clause.
Clause 20: The lens assembly of clause 19, further comprising a protective resistor configured to provide controlled discharge in the lens of capacitance in a power line.
Clause 21: A lens assembly for manipulating electron beamlets, comprising: an array substrate in which an array of apertures is defined for the path of electron beamlets; an adjoining substrate in which at least an aperture is defined for the path of the electron beamlets; and a protective resistor configured to provide controlled discharge in the lens of capacitance in a power line, wherein the lens assembly is configured to provide a potential difference between the substrates.
Clause 22: The lens assembly according to either of clauses 20 and 21, further comprising a circuit board electrically connected to the array substrate and/or the adjoining substrate; wherein preferably the protective resistor is electrically connected to the circuit board.
Clause 23: The lens assembly according to clause 22, wherein the circuit board comprises a ceramic material.
Clause 24: The lens assembly according to either of clauses 22 and 23, further comprising a connector configured to electrically connect the array substrate and/or the adjoining substrate to the circuit board; wherein the connector is surrounded by material of 25 kV/mm or greater.
Clause 25: The lens assembly according to either of clauses 22 and 23, wherein the circuit board is electrically connected to the array substrate and/or the adjoining substrate via a flip chip connection.
Clause 26: The lens assembly of any one of clauses 19 to 25, wherein the lens assembly is a condenser lens array and is configured to generate the electron beamlets from an electron beam emitted by a source, preferably the array of apertures defined in the array substrate generates the electron beamlets.
Clause 27: An objective lens assembly comprising the lens assembly of any one of clauses 18 to 24, further comprising a detector assembly down beam of the electron-optical device, the detector assembly comprising a detector array configured to detect electrons emitted from the sample, preferably at least portion of the detector being adjacent to and/or integrated with the objective lens array.
Clause 28: The objective lens assembly according to clause 27, wherein the detector assembly comprises a detection circuit board electrically connected to the detector array via a flip chip connection.
Clause 29: The objective lens assembly according to either of clauses 27 and 28, wherein the detector assembly comprises ceramic, preferably the detector assembly comprises a detection circuit board comprising a ceramic material.
Clause 30: The objective lens assembly according to any one of clauses 22 to 24, wherein the detector assembly further comprises a readout chip.
Clause 31: The objective lens assembly according to clause 30, wherein defined in the readout chip is an opening for the path of the electron beamlets, preferably the opening is array of openings.
Clause 32: The objective lens assembly according to either of clause 30 and 31, wherein defined in the readout chip are openings for the path of the beamlets, each opening corresponding to the path of at least one electron beamlet.
Clause 33: The objective lens assembly according to any one of clauses 30 to 32, wherein the detector array is disposed down beam of the readout chip.
Clause 34: The objective lens assembly according to any one of clauses 31 to 33, wherein the detector array is within the readout chip, preferably the detector array is down beam of the at least one opening in the readout chip, and/or the detector array provides a down beam surface of the readout chip.
Clause 35: The objective lens assembly of any of clauses 27 to 34, wherein the detector assembly is configured to be thermally conditioned.
Clause 36: The objective lens assembly of any of clauses 27 to 35, wherein signal communication with detector array comprises signal communication via optic fiber, the objective lens array assembly comprising optic fiber.
Clause 37: The objective lens assembly of any of clauses 27 to 36, wherein at least part of the detector assembly is spaced apart, preferably thermally isolated from the adjoining substrate, the at least part of the detector assembly preferably comprising: the detector array and/or the readout chip, optionally the detector assembly.
Clause 38: The lens assembly of any of clauses 19 to 37, further comprising a cooling circuit configured to thermally condition the lens assembly, wherein preferably the cooling circuit is in thermal contact with the detector assembly, and more preferably in thermal communication with the detection circuit board and thus the detector array.
Clause 39: An objective lens assembly for an electron-optical system of an electron beam tool, the objective lens array assembly being configured to focus a multi-beam on a sample and comprising: an objective lens array, each objective lens being configured to project a respective sub-beam of the multi-beam onto the sample; and a detector assembly comprising a detector array configured to detect electrons emitted from the sample, at least portion of the detector assembly preferably being adjacent to and/or integrated with the objective lens array wherein: at least the detector assembly preferably the detector array is configured to be thermally conditioned; signal communication to detector array comprises signal communication via optic fiber, the objective lens array assembly comprising optic fiber; and/or the objective lens array comprising the lens assembly of clause 19 to 25 or 27 to 37.
Clause 40 An electron-optical column configured to generate beamlets from a source beam and to project the beamlets towards a sample, the electron optical column comprising a detector facing the sample and comprising an array of current detectors, wherein: the detector assembly comprises a detector array configured to detect electrons emitted from the sample; at least the detector assembly is configured to be thermally conditioned; signal communication to the detector array comprises signal communication via optic fiber, the objective lens array assembly comprising optic fiber; and/or the detector assembly comprising the features of the detector assembly of any of clauses 27 to 37.
Clause 41; The electron-optical column according to clause 40, wherein the detector assembly comprises ceramic, preferably the detection circuit board comprises a ceramic material.
Clause 42: The electron-optical column according to either of clauses 40 and 40, wherein the detector assembly further comprises a readout chip.
Clause 43: An electron-optical system comprising: a source configured to emit an electron beam; and an electron optical column of any one of clauses 40 to 42 or comprising the objective lens assembly of any of clauses 27 to 39.
Clause 44: An electron-optical system array, comprising: a plurality of the electron-optical systems of clause 43, wherein: the electron-optical systems are configured to focus respective multi-beams simultaneously onto different regions of the same sample.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. An electron-optical device for manipulating electron beamlets, the device comprising:
an array substrate in which an array of apertures is defined for the path of electron beamlets, the substrate having a thickness which is stepped so that the array substrate is thinner in the region corresponding to the array of apertures than another region of the array substrate; and
an adjoining substrate in which another array of apertures is defined for the path of the electron beamlets;
wherein the electron-optical device is configured to provide a potential difference between the substrates.

2. The electron-optical device according to claim 1, wherein one of the array substrate and the adjoining substrate is upbeam of the other and preferably the upbeam substrate has a higher potential difference than the downbeam substrate.

3. The electron-optical device of claim 1 or 2 wherein a surface of the substrate between the thinner region of the substrate and the other region of the substrate is orthogonal to the surface of the substrate facing the adjoining substrate.

4. The electron-optical device of any of claims 1 to 3, further comprising a spacer disposed between the substrates to separate the substrates such that the opposing surfaces of the substrates are co-planar with each other, the spacer having an inner surface facing the path of the beamlets.

5. The electron-optical device of claim 4, wherein the spacer defines an opening, for the path of the electron beamlets.

6. The electron-optical device of claims 4 or 5, wherein the inner surface is shaped such that a creep path between the substrates over the inner surface is longer than a minimum distance between the substrates.

7. The electron-optical device of claim 6, wherein the inner surface comprises corrugations, preferably the corrugations are concentric and/or the corrugations surround the opening.

8. The electron-optical device of any of claims 4 to 6, wherein the array substrate comprises
a first wafer in which an aperture array is defined, disposed in contact with the spacer; and
a second wafer disposed on a surface of the first wafer in a region not corresponding to the aperture array.

9. The electron-optical device of any of claims 1 to 7, wherein the array substrate comprises a first wafer etched to generate the regions having different thicknesses.

10. The electron-optical device of any of claims 4 to 9, wherein the inner surface is stepped with an upper beam portion distanced further away from the path of the beamlets than a lower beam portion.

11. The electron-optical device of claim 10, wherein the opening in the lower beam portion of the inner surface of the opening in the spacer has a largest dimension,

12. The electron-optical device of any preceding claim, wherein the array of apertures defined in the adjoining substrate has the same pattern as the array of apertures defined in the array substrate.

13. A lens assembly for manipulating electron beamlets, comprising the electron-optical device of any preceding claim.

14. The lens assembly of claim 13, further comprising a protective resistor configured to provide controlled discharge in the lens of capacitance in a power line.

15. The lens assembly of claim 14, further comprising a circuit board electrically connected to the array substrate and/or the adjoining substrate;
wherein preferably the protective resistor is electrically connected to the circuit board.
